# EUROPEAN PATENT APPLICATION

(11) **EP 1 294 218 A1**
(43) Date of publication of application: **19.03.2003**
(21) Application number: 01967775.6
(22) Date of filing: 21.09.2001
(51) Int. Cl.: H05K 3/34, B23K 1/00, B23B 3/00, B05D 7/00, B23K 1/20, B23K 3/08

(54) **FLUX APPLYING METHOD, FLOW SOLDERING METHOD AND DEVICES THEREFOR AND ELECTRONIC CIRCUIT BOARD**

(30) Priority: 25.09.2000 JP 2000290256
(71) Applicant: MATSUSHITA ELECTRIC INDUSTRIAL CO., LTD., Kadoma-shi, Osaka 571-8501 (JP)
(72) Inventor: KAWASHIMA, Yasuji, Ibaraki-shi, Osaka 567-0006 (JP); SUETSUGU, Kenichiro, Nishinomiya-shi, Hyogo 662-0825 (JP); HIBINO, Shunji, Hirakata-shi, Osaka 573-0075 (JP); TAKANO, Hiroaki, Hirakata-shi, Osaka 573-0022 (JP); OKUJI, Tatsuo, Moriguchi-shi, Osaka 570-0002 (JP); KABASHIMA, Shoshi, Hirakata-shi, Osaka 573-0047 (JP); MAEDA, Yukio, Hirakata-shi, Osaka 573-0115 (JP); NAKATA, Mikiya, Suita-shi, Osaka 565-0806 (JP)
(74) Representative: Eisenführ, Speiser & Partner
(86) International application number: JP0108227
(87) International publication number: WO02026006

(57) **Abstract**

It is realized that a solder material is sufficiently supplied to a through hole formed through a board by a spraying mode flux applying method in a flow soldering process for mounting an electronic component onto the board by means of a solder material.

In the spraying mode flux applying method for applying the flux including an active ingredient and a solvent onto the board by spraying the flux toward the board from a nozzle, the flux is sprayed and adheres to the board while remaining in a state of solution. More specifically, a distance between the nozzle for spraying the flux toward the board and the board located over the nozzle is set at about 30 to 60 mm.

## Description

### Technical Field

The present invention relates to a method for applying flux in a process for mounting a component(s) such as an electronic component(s) onto a board (or substrate) by means of a solder material as well as a device for such method. The present invention also relates to a process and an apparatus for flow soldering (or wave soldering) which utilize the method and the device for applying flux respectively, and to an electronic circuit board produced by such flow soldering process.

### Background Art

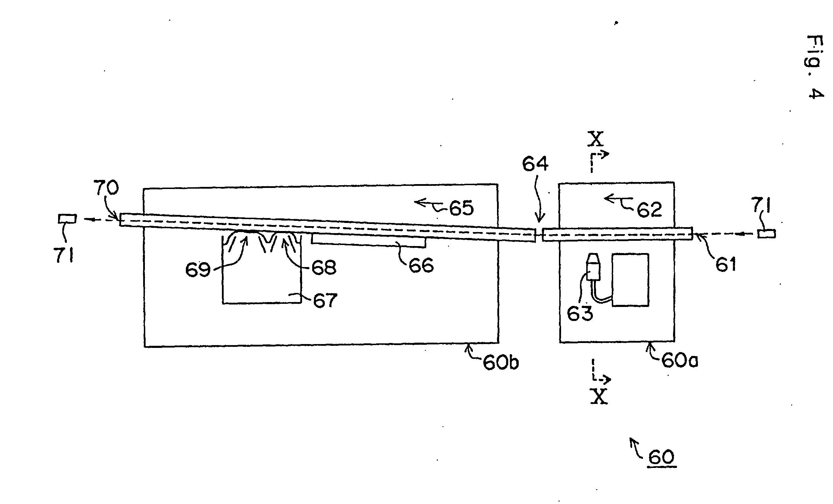

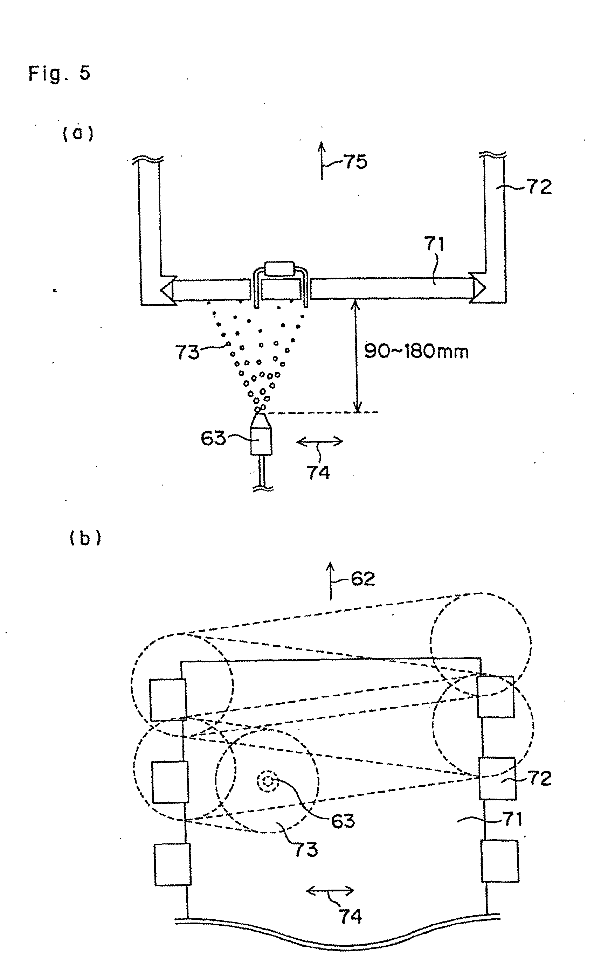

A flow soldering process utilizing a solder wave(s) is conventionally known as one of processes for connecting an electronic component or the like to a board in the field of production of an electronic circuit board. Such flow soldering process generally includes a flux applying step for applying flux onto a board, a preheating step for heating the board in advance, and a solder material supplying step for supplying a solder material by contacting the board with a wave(s) of the solder material. Hereinafter, the conventional flow soldering process will be described with reference to the drawings. Fig. 4 shows a schematic side view of the conventional flow soldering apparatus while showing its internal construction. Fig. 5 (a) illustrates a manner where flux is applied onto a board locating in a cross section taken along an X-X line in Fig. 4. Fig. 5 (b) shows a schematic top view of a part of the board shown in Fig. 5(a).

As shown in Fig. 4, the conventional flow soldering apparatus 60 consists of a spray fluxer 60a and a main part 60b of the flow soldering apparatus. The spray fluxer 60a is a device for applying the flux onto the board. In the apparatus 60, the flux applying step is conducted in the spray fluxer 60a, and then the preheating step and the solder material supplying step are conducted in the main part 60b in series.

At first, the spray fluxer 60a is fed with a board 71 through an inlet 61 thereof. The board 71 is, for example, a printed circuit board on which an electronic component such as a "through hole insertion component" (that is, a component a part of which is inserted into a through hole, for example, a discrete component or a lead component) is mounted at a predetermined position according to a known manner. The board 71 is mechanically conveyed in a direction of an arrow 62 inside the spray fluxer 60a (along a conveyance line shown as a broken line in Fig. 4) at a substantially constant speed. More specifically, the conveyance of the board 71 is conducted by holding the board 71 with conveyance fingers 72 at its edge portions as shown in Figs. 5 (a) and (b) and by mechanically moving the conveyance fingers 72 in the conveyance direction of the arrow 62 (see, Fig. 5 (b)). When the board 71 conveyed as described above reaches a position over a nozzle 63 in due course, flux 73 is applied onto a lower surface of the board 71 by spraying the flux 73 together with air from the nozzle 63 while reciprocating the nozzle 63 in a vertical plane as to the conveyance direction of the board 71 (i.e. the direction of the arrow 62 in Figs. 4 and 5 (b)), in other words, reciprocating it in directions of a left and right arrow 74 in Figs. 5 (a) and (b) which is vertical to a plane of the sheet of Fig. 4. The nozzle 63 generally has a circular aperture for spray. The flux 73 sprayed from the nozzle is microscopically in the form of liquid droplets, which altogether form a truncated conical form (or a generally conical form) which has a spray aperture of the nozzle 63 as an upper base (or an apex) and an application region of the lower surface of the board 71 as a lower base. The board 71 is conveyed in a direction of the arrow 62 while the nozzle 63 reciprocates in the directions of the arrow 74 over a length corresponding to a width of the board 71 at a speed depending on the conveyance speed of the board 71. As a result, a circular region of the flux 73 which is applied onto the board at the same time traverses over the lower surface of the board 71 slantly with respect to the conveyance direction of the board 71 as shown in Fig. 5 (b), so that the flux 73 is applied onto the whole of the lower surface of the board 71.

The flux applying step as describe above is conducted in order to improve wettability and a spreading property of the solder material on a surface of a land formed on or through the board 71 (i.e. a portion to be supplied with the solder material) by removing an oxide film (a naturally oxidized film) which is unavoidably formed on the land. The flux 73 applied onto the board 71 generally contains an active ingredient such as rosin as well as a volatile solvent such as isopropyl alcohol. Because of a high volatility of the solvent, the spray fluxer 60a is provided with an exhaust duct (not shown) over the conveyance line of the board 71 for safety, and the volatile solvent is suctioned and discharged together with an atmosphere gas in a direction of an allow 75 (Fig. 5(a)).

The board 71 applied with the flux as described above is then mechanically transferred from the spray fluxer 60a to the main part 60b of the apparatus at a point 64 shown in Fig. 4. The board 71 is mechanically conveyed in a direction of an arrow 65 inside the main part 60b of the apparatus (along the conveyance line shown as a broken line in Fig. 4) at a substantially constant speed as in the spray fluxer 60a. The board 71 is heated by a preheater 66 such as a far infrared heater while it is conveyed as described above. Such heating step is referred to as a preheating step. The preheating step is conducted for vaporizing and removing an unnecessary solvent ingredient among the flux 73 applied onto the board through the above flux applying step so as to leave only the active ingredient on the board 71, and for preheating the board 71 prior to supply of a solder material 67 to the board 71 so as to alleviate a heat shock of the board 71 upon contacting the board 71 with a molten solder material 67.

The board 71 is subsequently contacted at its lower surface with a primary wave 68 and a secondary wave 69 of the solder material 67 which is in a molten state by heating beforehand, so that the solder material 67 is supplied to the board 71. In this step, the solder material rises in an annular space between a land portion and a lead of the through hole insertion component from a lower side of the board by the capillary phenomenon wherein the land portion forms a wall of the through hole perforated through the board and the lead is inserted into the through hole from an upper side of the board. Then, the solder material which is supplied and adheres to the board 71 solidifies with a drop in its temperature and forms a so-called "fillet" as a connection portion of the solder material. In such solder material supplying step (or flow soldering step), the primary wave is directed for sufficiently wetting a surface of the land formed on the wall of the through hole (as well as the lead of the electronic component) with the solder material and supplying the solder material into the through hole. The secondary wave is directed for removing an excess amount of the solder material which adheres to an area of the lower surface of the board covered with a solder resist and conditioning the form of the fillet so as to avoid that the solder material remains on an area between lands and solidifies thereon to form a "bridge" (such bridge is undesirable since it causes a short circuit) or that a ceratoid projection is formed. Thus, the resultant board 71 is thereafter taken out through an outlet 70.

As described above, an electronic circuit board is produced wherein the electronic component is soldered to the board according to the flow soldering process.

The connection portion of the solder material (fillet) as described above is required to have a sufficiently high connection strength between the lead of the electronic component and the land on the board to obtain a high reliability of the electronic circuit board. In the conventional flow soldering process in which a spraying mode flux applying method is used for ejecting atomized flux onto the board by means of the spray fluxer as described above, decrease in a connection strength is encountered especially in the case of using a lead-free solder material as the solder material. Such a problem results from the fact that the solder material does not sufficiently supplied to the annular space between the lead and the land portion which forms a wall of the through hole.

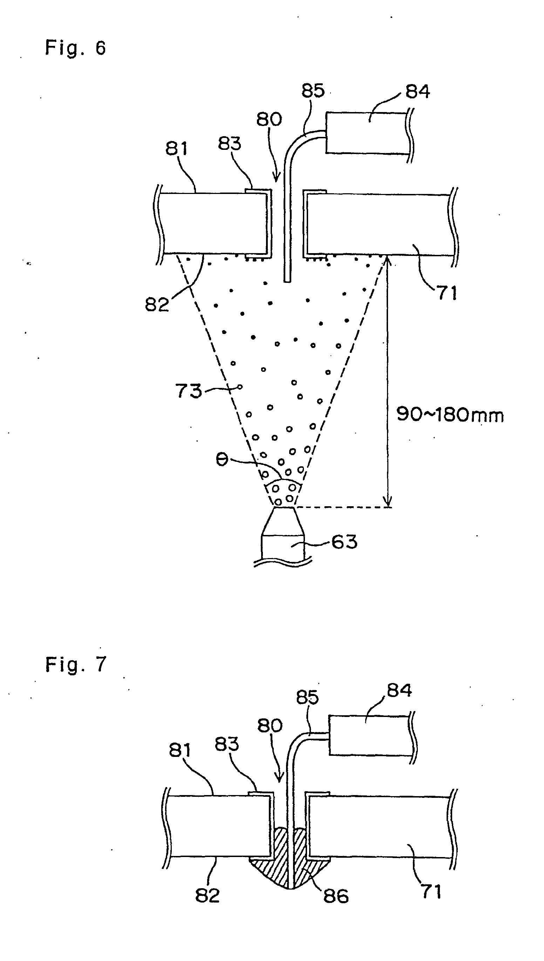

As to a general board subjected to the flow soldering, as shown in Fig. 6, a through hole 80 is formed through the board 71, and a land 83 made of, for example, copper or the like is formed integrally on a wall of the through hole 80 and areas surround the through hole 80 on an upper surface 81 and a lower surface 82 of the board 71. The land 83 is connected to a wiring pattern (not shown) formed on the upper surface 81 of the board 71. Further, a lead 85 (such as an electrode) which is drawn out from a through hole insertion component (electronic component) 84 is inserted into the through hole 80 from a side of the upper surface 81 of the board 71. A nozzle 63 is generally located under the board 71 at a distance of about 90 to 180 mm from the lower surface 82 of the board 71. Flux 73 is sprayed from the nozzle 63 toward the lower surface 82 of the board 71 together with air to apply the flux 73 onto the board 71.

Thus resultant board to which the flux is applied is subjected to the preheating step and the solder material supplying step as described above to produce the electronic circuit board. When a solder material containing no lead, a so-called "lead-free" solder material, is used for the solder material supplying step, a fillet 86 as shown in Fig. 7 may be formed wherein the solder material rises up to the middle of the through hole 80. Such phenomenon in which a portion of the land 83 locating on the upper surface 81 is not covered with the solder material and exposed to an ambient is considered as "insufficient rising (or wetting up)" (shortage of the supply of the solder material to the through hole resulting from insufficient rising of the solder material by the capillary action), and it is undesirable.

Such phenomenon remarkably occurs in the case of using the lead-free solder material though it has hardly been encountered in the case of using an Sn-Pb based material as a solder material. The problem of the "insufficient rising" is undesirable since it brings about a decreased connection strength by means of the fillet 86 between the land 83 and the lead 85, and may cause deposition of a contaminant such as a salt material, which may exists in the atmosphere, on a recess formed on the fillet 86 in the through hole 80 whereby a lowered reliability of an electronic circuit board is occasionally caused.

In addition to the spraying mode flux applying method as described above, a method in which a board is contacted with foamed flux by means of a foam fluxer, i.e. a foaming mode flux applying method, is also used as the method for applying flux onto the board. It has been proved that an occurrence ratio of the "insufficient rising" is decreased in the case of using the foaming mode flux applying method compared with using the spraying mode flux applying method.

However, it has been known that the spraying mode flux applying method is more appropriate to a flow soldering of a surface mount component than the foaming mode flux applying method though the foaming mode flux applying method is suited to the flow soldering of the through hole insertion component. Thus, in the case of using the foaming mode flux applying method for a board which includes not only a through hole insertion component but also a surface mount component on a lower surface of the board, insufficient connection is formed as to the surface mount component though a good connection is obtained as to the through hole insertion component. Therefore, there is other problem in the foaming mode flux applying method.

Furthermore, the flux is recycled in the foaming mode flux applying method while exposed to the atmosphere, so that moisture in the atmosphere is mixed into the flux to change a composition of the flux with time. This needs to control a concentration of a component(s), especially an active ingredient, in the flux. Such problem is particular to the foaming mode flux applying method and does not encountered in the spraying mode flux applying method. Thus, using the foaming mode flux applying method in place of the spraying mode flux applying method in order to decrease the occurrence ratio of the "insufficient rising" is not exactly satisfying.

### Disclosure of Invention

The present invention is directed to solve the prior art problems as described above. The present invention aims to provide a spraying mode flux applying method used in a flow soldering process for mounting an electronic component onto a board with a solder material, wherein the solder material can be sufficiently supplied to a through hole formed through the board. The present invention also aims to provide a flow soldering process utilizing such flux applying method and an apparatus and a device for conducting the flux applying method and the flow soldering process respectively, as well as an electronic circuit board produced by such flow soldering process.

The inventors have studied reasons why the occurrence ratio of the "insufficient rising" in the case of using a lead-free solder material in the flow soldering process is larger than that in the case of using an Sn-Pb based material when the spraying mode flux applying method is utilized. Then, we have come to the considerations as below:
Upon utilizing the conventional spraying mode flux applying method, the reason why the occurrence ratio of the "insufficient rising" in the case of using the lead-free solder material is larger than that in the case of using the Sn-Pb based solder material is considered to lie in difference of wettability as to a land between these solder materials.

According to the conventional spraying mode flux applying method, it has been proved that flux 73 ejected from the nozzle 63, as shown in Fig. 6, scarcely adheres to a wall of the through hole 80 (i.e. a surface of a land 83 locating in the through hole 80 which surface generally has a cylindrical or cylindroid configuration (in the case of for example a through hole being ellipsoid in its section)) though it adheres to the lower surface 82 of the board 71 sufficiently. When the through hole 80 has an inner diameter of about 0.4 to 5 mm and a height of about 0.8 to 2.0 mm, it has been found that the flux 73 does not adhere to the wall of the through hole 80 up to a sufficient height from the lower surface 82 of the board 71 in a direction of a thickness of the board 71. The flux functions to improve the wettability and the spreading property of the solder material as described above. Such function is not effected as to an area of the surface of the land to which area the flux does not adhere.

In the case of using the conventional Sn-Pb based solder material (which is generally an Sn-Pb eutectic material), even though the flux does not sufficiently adhere to the wall of the through hole in the flux applying step, the solder material which is supplied in the following solder material supplying step wets and rises up an annular space between the land 83 and the lead 85 and spreads over a surface portion of the land 83 locating on the upper surface 81 of the board 71 while fully filling the through hole 80 so as to form a fillet covering the surface of the land 83 locating on the upper surface 81 of the board 71, since the Sn-Pb based solder material essentially has a sufficient wettability. On the contrary, it can be considered that the lead-free solder material is likely to cause the "insufficient rising" since the lead-free solder material has a lower wettability than that of the Sn-Pb based material and therefore does not wet and rise up the annular space between the land 83 and the lead 85 sufficiently.

On the other hand, it is considered that foamed flux which generally has a diameter of about 1 to 2 mm bursts and scatters into its fine droplets upon application according to the foaming mode flux applying method, so that it can adhere to an area of the wall of a through hole 80 up to a higher level with respect to the lower surface of the board than such level in the spraying mode flux applying method. As a result, the wettability of the solder material with respect to the wall of the through hole can be improved in the case of using the lead-free solder material. Therefore, the lead-free solder material wets and rises up the wall of the through hole and spreads over the land portion locating on the upper surface of the board, so that the occurrence ratio of the "insufficient rising" can be maintained at a lower extent as in the case of using the Sn-Pb based solder material.

Based on the considerations as described above, we have concluded that the lower extent of occurrence ratio of the "insufficient rising" can be achieved even in the case of using the lead-free solder material if the flux is made to sufficiently adhere to the wall of the through hole in the spraying mode flux applying method.

According to the investigations of the inventors, it is supposed that the substantially whole of the solvent contained in the flux is vaporized before reaching (or adhering to) the board in the conventional spraying mode flux applying method (for example, the substantially whole of the solvent is vaporized at a position of about 50 mm from the nozzle). The volatile solvent forming the flux, e.g. isopropyl alcohol, is a major part of the flux and generally contained in the flux at about 80 to 97 % by weight (on the basis of the total weight of the flux). Thus, when most or substantially all of the solvent is vaporized, a composition of the flux is notably changed and a relative ratio in amount of an active ingredient (solute) such as rosin contained in the flux is remarkably increased. Since the active ingredient such as the rosin has a relatively high viscosity or tackiness (for example, the rosin itself is a solid having tackiness at a normal temperature and pressure), a viscosity or tackiness of the flux itself becomes higher as the ratio of the active ingredient increases, and this makes the wettability of the flux decrease before the flux reaches the board. As a result, the flux adhering to the board is unlikely to wet and spread over the flux adhering surface. Understanding this in reverse, it is conceived that increase in the viscosity and decrease in the wettability of the flux can be suppressed by decreasing an amount of the solvent to be vaporized before the flux reaches the board and therefore by making the flux reach the board while keeping it in a state of solution, so that the flux adhering to the board can wet and spread over a larger area of the flux adhering surface. We have accomplished the present invention as described below based on the above considerations.

In one aspect of the present invention, there is provided a flux applying method for applying flux which contains an active ingredient and a solvent onto a board by spraying the flux toward the board from a nozzle, which method is used in a flow soldering process for mounting an electronic component onto the board by means of a solder material, characterized in that the flux which has been sprayed adheres to the board while the flux substantially remains in a state of solution. It is noted that the "state of solution" in the present specification means a state wherein droplets of the flux sprayed from the nozzle have a certain concentration of the active ingredient (or solute) in the flux so as to be able to unite and form a liquid film when they adjoin and contact with each other on a flux adhering surface of the board (e.g. land).

According to the method of the present invention, since the flux adheres to the board while remaining in the state of solution, the decrease in the wettability of the flux with respect to the land can be substantially avoided. The flux having a sufficient wettability and adhering to a land portion locating on a lower surface of the board, and preferably on a land portion locating on a wall of a through hole, can spread on the flux adhering surface and rise through the through hole over its wall, and preferably spread onto a land portion locating on an upper surface of the board. Therefore, the flux can be applied not only onto the lower surface of the board but also onto an area of the wall of the through hole up to a higher level than that in the conventional spraying mode flux applying method and preferably onto the land portion locating on the upper surface of the board (therefore, onto the whole of the surfaces of the land). Therefore, in a solder material supplying step which follows to the flux applying step, it is possible to improve the wettability of the solder material and maintain an occurrence ratio of the "insufficient rising" at a low level even in the case of using the lead-free solder material as the solder material.

The method of the present invention as described above improves the conventional spraying mode flux applying method. Even if the lead-free solder material is used, the occurrence ratio of the "insufficient rising" upon soldering a through hole insertion component in a flow soldering process can be equal to or less than that in the case of using the conventional foaming mode flux applying method. Additionally, though the conventional foaming mode flux applying method has a problem in that it is not satisfactory for applying the flux onto a surface mount component, the spraying mode flux applying method of the present invention has an advantage in that it does not have such a problem.

In another aspect of the present invention, there is provided a flux applying method for applying flux which contains an active ingredient and a solvent onto a board by spraying the flux toward the board from a nozzle, which method is used in a flow soldering process for mounting an electronic component onto the board by means of a solder material, characterized in that a distance between the nozzle and the board which is located over the nozzle is about 30 to 60 mm.

Conventionally, the distance between the nozzle and the board is generally about 90 to 180 mm. We have found that the occurrence ratio of the "insufficient rising" can be retained at a low extent even in the case of using the lead-free solder material by setting the nozzle closer to the board while making such distance being in a range of about 30 to 60 mm which is about one third of the conventional distance, and preferably in a range of about 30 to 50 mm. This seems to result from that a period after the flux is sprayed and before adheres to the board is made shorter than that in the conventional method, so that the sprayed flux can adhere to the board while substantially remaining in the state of solution, so that the effects as described above are achieved. Furthermore, since the distance between the nozzle and the board is shortened according to this method, the flux can reaches the board at a larger velocity and with a larger drop size than those in the conventional method even with the similar flux flow rates. As a result, the flux can be supplied vigorously toward the board up to a level higher than that in the conventional method with respect to the lower surface of the board, and preferably at an extent such that at least a part of the flux passes through the through hole. Such an effect also contributes to retaining the occurrence ratio of the "insufficient rising" at the low degree even in the case of using the lead-free solder material.

It can be conceivable for those skilled in the art to appropriately adjust a velocity of a reciprocating movement of the nozzle, a number of the nozzles, a spreading angle of the flux sprayed from the nozzle, a composition of the flux, flow rates of the flux and other gas(es) such as air sprayed together with the flux, a shape and a size of a spraying opening of the nozzle, a conveyance speed of the board and so on while taking the distance between the board and the nozzle into consideration in the method of the present invention. In addition, it is also possible to, for example, increase an ejection rate of the flux, modify the droplet size of the flux ejected from the nozzle or select an atmosphere comprising a solvent for the ambient atmosphere. In a preferred embodiment of the present invention, the flux is applied onto, in addition to the lower surface of the board, a partial area of the wall of the through hole formed through the board (which wall is a surface of a land portion locating in the through hole, or a cylindrical surface part of the land) up to a level at least one third of a thickness of the board from the lower surface of the board in a thickness direction of the board, preferably the whole area of the wall, and more preferably the whole surfaces of the land (i.e. the land surfaces locating in the through hole and on the upper and lower surfaces of the board).

These methods of the present invention are suited particularly in the case of using the lead-free solder material such as an Sn-Cu based material, an Sn-Ag-Cu based material, an Sn-Ag based material, an Sn-Ag-Bi based material and an Sn-Ag-Bi-Cu based material as the solder material used in the flow soldering process. However, the present invention is not limited to those, and it is also possible to use a solder material containing lead such as an Sn-Pb based solder material.

In another aspect of the present invention, there is provided a flow soldering process which utilizes the spraying mode flux applying method of the present invention as described above. In a preferred embodiment, the flow soldering process includes the spraying mode flux applying method of the present invention in combination of the foaming mode flux applying method in which the foamed flux is applied onto the board by contacting with the board. For instance, the flux can be applied onto the board according to the spraying mode method followed by the foaming mode method or vice versa. This can make the board surface (particularly, the land surfaces formed in the board) wetted with the flux more sufficiently than that in the case using the spraying mode flux applying method of the present invention alone.

In yet another aspect of the present invention, there is provided an electronic circuit board which is produced by applying flux onto a board and thereafter soldering an electronic component onto the board by means of a solder material according to the flow soldering process of the present invention as described above. As to the electronic circuit board, since the solder material can wet and rise up a through hole and is sufficiently supplied to the board, it is possible to effectively prevent the occurrence of the "insufficient rising" and therefore improve a connection strength between the board and the electronic component by means of a fillet of the solder material.

In further another aspect of the present invention, there is provided a flux applying device (or a flux applicator) used in a flow soldering process for mounting an electronic component onto a board by means of a solder material, characterized in that the device is provided with a nozzle for applying flux which contains an active ingredient and a solvent onto the board by spraying the flux toward the board such that the flux adheres to the board while the flux substantially remains in a state of solution (or while the solvent contained in a droplet of the sprayed flux substantially remains in its liquid state). Further, there is also provided a flux applying device used in a flow soldering process for mounting an electronic component onto a board by means of a solder material, characterized in that the device is provided with a nozzle for applying onto the board flux which contains an active ingredient and a solvent by spraying the flux toward the board, and a distance between the nozzle and the board which is located over the nozzle is 30 to 60 mm. These devices are preferably used for conducting the flux applying method of the present invention as described above.

In a preferred embodiment, the flux is applied onto a partial area of a wall of a through hole formed through the board up to a level at least one third of a thickness of the board from the lower surface of the board over the nozzle in a direction of a thickness of the board, and preferably onto the whole area of the wall.

These devices for applying the flux of the present invention can constitute a flow soldering apparatus either separately from its main part as in the apparatus for the conventional flow soldering process as described with reference to the drawings, or integrally with its main part of the apparatus by being incorporated into the apparatus. The flux applying device of the present invention is used in the flow soldering apparatus in combination with the foaming mode flux applying device in which the foamed flux is contacted with the board.

It is noted that the "flux" in the present specification denotes a material which is applied in order to remove oxides from a surface of a metal to be supplied with a solder material (which metal is a land, for example) for improving the wettability of the solder material on the metal. The flux contains an active ingredient for removing the oxides as well as a solvent for facilitating handling of the active ingredient. For example, a content of the active ingredient may exist at about 3 to 20 % by weight, and a content of the solvent may exist at about 80 to 97 % by weight. The active ingredient includes rosin, an organic acid (e.g. diphenylguanidine hydrobromide) and so on, and the solvent includes isopropyl alcohol and so on. The flux may further contain other component(s) such as a matting agent in a little amount in addition to the active ingredient and the solvent. For example, it is possible to use a material which is commercially available as the flux.

As the board applicable to the present invention, it is possible to use, for example, a substrate of a paper phenol based material, a glass epoxy resin based material, a polyimide film based material, a ceramic based material or other material. On the other hand, the electronic component which is connected (or soldered) to the board can be a through hole insertion component (e.g. a semiconductor device, a capacitor, a resistor, a coil, a connector, a metal casing of a sub-substrate and so on) and/or a surface mount component located on a back surface of the board (e.g. a semiconductor device, a capacitor, a resistor, a coil and so on). However, these are merely mentioned for the exemplary purpose, and should not be interpreted as any limitation of the present invention.

The present invention includes Modes 1 to 15 as follows:
(Mode 1) A flux applying method for applying flux which includes an active ingredient and a solvent onto a board by spraying the flux toward the board from a nozzle in a flow soldering process for mounting an electronic component onto the board by means of a solder material, wherein the flux is sprayed and adheres to the board while substantially remaining in a state of solution.
(Mode 2) A flux applying method for applying flux onto a board by spraying the flux which includes an active ingredient and a solvent toward the board from a nozzle in a flow soldering process for mounting an electronic component onto the board by means of a solder material, wherein a distance between the nozzle and the board which is located over the nozzle is 30 to 60 mm.
(Mode 3) The method according to Mode 1 or 2, wherein the flux is applied to a region of a wall of a through hole formed through the board, and the region is from a lower surface of the board which is closer to the nozzle to a level of at least one third of a thickness of the board in a direction of the thickness of the board.
(Mode 4) The method according to Mode 3, wherein the flux is applied to a whole region of the wall.
(Mode 5) The method according to any one of Modes 1 to 4, wherein the solder material is a lead-free solder material selected from the group consisting of an Sn-Cu based material, an Sn-Ag-Cu based material, an Sn-Ag based material, an Sn-Ag-Bi based material, and an Sn-Ag-Bi-Cu based material.
(Mode 6) A flow soldering process, which comprises the method for applying the flux according to any one of Modes 1 to 5.
(Mode 7) The process according to Mode 6, which further comprises applying the flux onto the board by contacting foamed flux with the board.
(Mode 8) An electronic circuit board produced by soldering an electronic component to the board by means of a solder material according to the process of Mode 6 or 7.
(Mode 9) A flux applying device which is used in a flow soldering process for mounting an electronic component onto a board by means of a solder material, characterized in that it comprises a nozzle for applying flux which includes an active ingredient and a solvent onto the board by spraying the flux toward the board such that the flux adheres to the board while the sprayed flux remains substantially in a state of solution or while the solvent contained in a droplet of the sprayed flux remains substantially in a liquid state.
(Mode 10) A flux applying device which is used in a flow soldering process for mounting an electronic component onto a board by means of a solder material, characterized in that it comprises a nozzle for applying flux which includes an active ingredient and a solvent onto the board by spraying the flux toward the board, and a distance between the nozzle and the board which is located over the nozzle is 30 to 60 mm.
(Mode 11) The device according to Mode 9 or 10, wherein the nozzle applies the flux onto a region of a wall of a through hole formed through the board, and the region is from a lower surface of the board which is closer to the nozzle to a level of at least one third of a thickness of the board in a direction of the thickness of the board.
(Mode 12) The device according to Mode 11, wherein the nozzle applies the flux onto a whole region of the wall.
(Mode 13) The device according to any one of Modes 9 to 12, wherein the solder material is a lead-free solder material selected from the group consisting of an Sn-Cu based material, an Sn-Ag-Cu based material, an Sn-Ag based material, an Sn-Ag-Bi based material and an Sn-Ag-Bi-Cu based material.
(Mode 14) A flow soldering apparatus comprising the flux applying device according to any one of Modes 9 to 13.
(Mode 15) The apparatus according to Mode 14 further comprising a foaming mode flux applying device which contacts foamed flux with the board.

### Brief Description of Drawings

Fig. 1 (a) schematically shows a cross sectional view of a board along a direction vertical to a conveyance direction of a board for explaining a flux applying method in one embodiment of the present invention, and Fig. 1 (b) schematically shows a top view of a part of the board in Fig. 1 (a);
Fig. 2 schematically shows an enlarged view of the part of the board for explaining the flux applying method in the embodiment of Fig. 1;
Fig. 3 schematically shows an enlarged cross sectional view of a part of an electronic circuit board produced by one embodiment of a flow soldering process of the present invention which uses one embodiment of the flux applying method of Fig. 1;
Fig. 4 schematically shows a cross sectional view of a conventional flow soldering apparatus;
Fig. 5 (a) illustrates a manner for applying flux onto a board locating across a cross section taken along an X-X line of Fig. 4, and Fig. 5 (b) schematically shows a top view of a part of the board in Fig. 5 (a);
Fig. 6 schematically shows an enlarged view of a flux applied part of the board of Fig. 5 (a); and
Fig. 7 schematically shows an enlarged cross sectional view of a part of an electronic circuit board produced by a conventional flow soldering process, wherein the part corresponds to the part of the board shown in Fig. 6.

### Embodiments for Carrying Out the Invention

### (Embodiment 1)

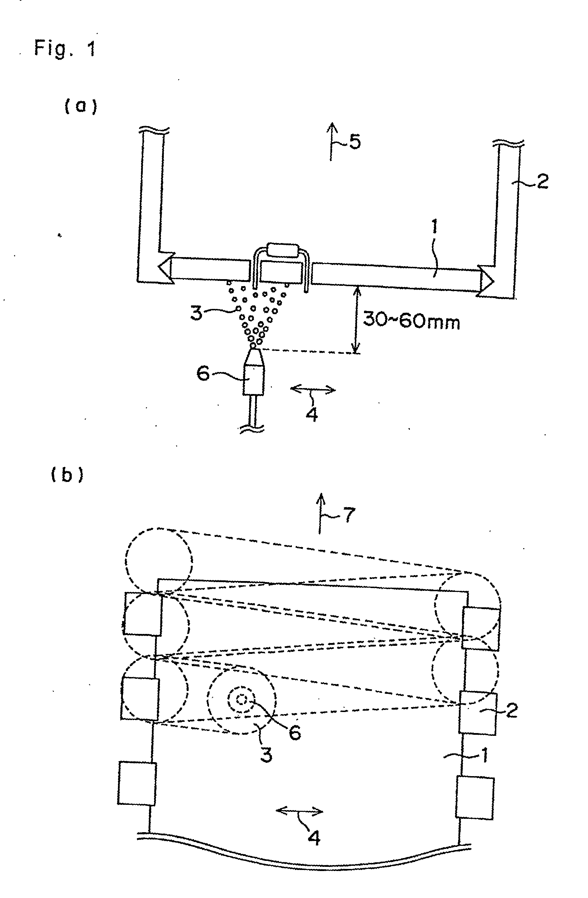

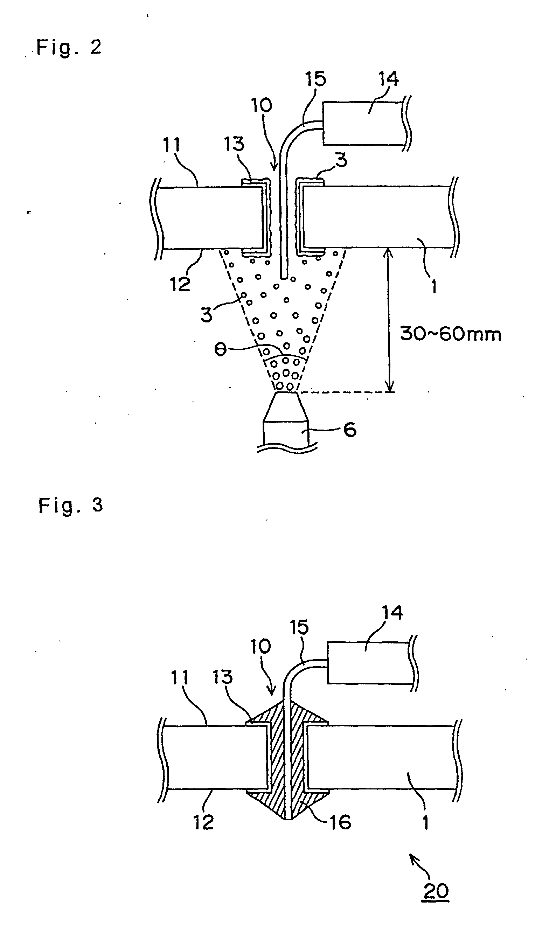

Hereinafter, one embodiment of the present invention will be described with reference to Figs. 1 (a) and (b) and Fig. 2. Figs. 1 (a) and (b) correspond to Figs. 5 (a) and (b) respectively which describe the conventional flux applying method. It is noted that the present embodiment will be described mainly about points different from the conventional flux applying method and device, and descriptions of constituents of the present embodiment similar to those of the conventional ones are omitted.

Though a spray fluxer (a flux applying device) similar to the conventional spray fluxer 60a which is described with reference to Fig. 4 is used for the flux applying method of this embodiment, the spray fluxer in this embodiment is different from the conventional one in that the distance between the nozzle 6 (which corresponds to the nozzle 63 in Fig. 5) and the board 1 is set at about 30 to 60 mm and preferably about 30 to 50 mm as shown in Fig. 1 (a).

An ambient gas is suctioned in a direction of an arrow 5 through an exhaust duct (not shown) as shown Fig. 1 (a) and the board 1 is conveyed by means of conveyance fingers 2 in a direction of an arrow 7 shown in Fig. 1 (b), which direction is perpendicular to the sheet of Fig. 1 (a). While the board is conveyed as above, flux 3 containing a solvent (such as isopropyl alcohol) and an active ingredient (such as rosin) is sprayed by the spray fluxer described above toward a lower surface of the board 1 from the nozzle 6 which reciprocates in directions of a left right arrow 4. Thus, the flux which is sprayed can adhere to the board 1 while substantially remaining in a state of solution. As a result, the flux spreads over and adheres to, preferably in a form of a liquid film, not only the lower surface 12 of the board 1 but also an area of a wall of the through hole into which a lead 15 of an electronic component 14 has been inserted. The wall is a cylindrical surface portion of the land 13 locating through the through hole. The area is up to a level of at least one third of a thickness of the board from the lower surface 12 in a direction of the thickness of the board, and preferably the whole of the wall. The flux more preferably spreads over and adheres further to a portion of the land 13 locating on an upper surface 11 in addition to the area of the wall of the through hole. The more preferable manner is shown in Fig. 2. The flux 3 preferably forms a liquid film (not shown) on also the surface of the lead 15 likewise.

The conventional nozzle may be converted to the nozzle 6, and it is relocated closer to the board as described in this embodiment. According to such a configuration though the distance between the nozzle and the board is decreased to about, for example, one third of that in the conventional configuration, a spreading angle θ (Fig. 2) of the flux which is sprayed from the nozzle is the same as the angle θ (Fig. 6) in the conventional configuration. Therefore, an application area on the lower surface of the board, to which area the flux reaches simultaneously, becomes smaller than that in the conventional method. (Compare the generally circular area in Fig. 1 (b) onto which the flux 3 is applied with the generally circular area in Fig. 5 (b) onto which the flux 73 is applied.) In order to apply the flux onto the whole of the lower surface of the board, it is therefore necessary in this case to make a velocity of the reciprocating motion of the nozzle larger than that in the conventional method by taking the conveyance speed of the board 1 and so on into consideration. Alternatively, the spreading angle of the flux to be sprayed from the nozzle may be varied appropriately. Additionally, plural nozzles can be used for applying the flux so as to cover the whole plane of the board though a single nozzle is used in this embodiment.

As described above, according to this embodiment, it is possible to apply the flux sufficiently onto the whole area of the wall of the through hole formed through the board and preferably even onto the upper surface of the land portion locating on the upper surface of the board.

The spray fluxer which is separated from the main part of the flow soldering apparatus is used in this embodiment. However, it is noted that a flux applying device provided with the nozzle for applying the flux can be installed in the main part to integrally form the flow soldering apparatus. Further, the device can be used in combination with a foam fluxer.

### (Embodiment 2)

This embodiment relates to a process and an apparatus for flow soldering which utilizes the flux applying method and the flux applying device (which is the spray fluxer in Embodiment 1) as described in Embodiment 1. The flow soldering apparatus of this embodiment is one obtained by substituting the spray fluxer (the flux applying device) described in the above Embodiment 1 for the spray fluxer 60a in the flow soldering apparatus 60 as described with reference to Fig. 4.

Using the spray fluxer described in Embodiment 1, the flux is firstly applied onto the board provided with an electronic component(s) appropriately in a manner as in Embodiment 1. Then, thus resultant board enters the main part 60b of the flow soldering apparatus described with reference to Fig. 4, so that the board is subjected to a preheating step and a solder material supplying step which are similar to the steps in the conventional process so as to finish the flow soldering process.

According to the operations as described above, an electronic circuit board 20 as shown in Fig. 3 is produced, in which the fillet 16 of the solder material is formed. The fillet 16 having such a form as shown in Fig. 3 can be formed not only in the case of using the Sn-Pb based solder material as the solder material, but also in the case of using a lead-free solder material. The lead-free solder material applicable to the present invention can be exemplified with an Sn-Cu based material, an Sn-Ag-Cu based material, an Sn-Ag based material, an Sn-Ag-Bi based material, an Sn-Ag-Bi-Cu based material and so on, and preferably the Sn-Cu based material and the Sn-Ag-Cu based material.

When the lead-free solder material is used as the solder material, it is desirable to estimate and control a quality of the lead-free solder material in a solder bath. For this purpose, a sensor which applies a principal of the differential thermal analysis to estimate the quality of the lead-free solder material can be used. Such a sensor is described in Japanese Patent Application No. 2001-171044 which claims domestic priorities from Japanese Patent Applications Nos. 2000-168903 and 2000-168904. It is noted that the contents of those applications are incorporated herein by the reference thereto in their entirety.

As to the electronic circuit board wherein the fillet having the form as shown in Fig. 3, the occurrence of the "insufficient rising" is effectively suppressed and preferably substantially eliminated. The fillet having such form makes it possible to connect a lead extending from an electronic component with a land formed on a board with a sufficiently high connection strength. Additionally, the fillet taking such form does not have a recess, otherwise a salt material existing in an atmosphere deposits in such a recess. Thus, decrease in the reliability of the electronic circuit board derived from the deposition of contaminants on the recess does not arise.

### Example

The flux applying method and the device (the spray fluxer) of the Embodiment 1 were carried out under the conditions as below.

In this example, a printed circuit board was used as a board which had, for example, a length of about 100 to 300 mm, a width of about 100 to 300 mm and a thickness of about 0.8 to 2.0 mm. Through holes formed through the board had a cylindrical shape of which inner diameter was about 0.6 to 5 mm. A lead to be coaxially inserted in the through hole had a rod-like shape of which sectional profile was circle having an outer diameter of about 0.5 to 4 mm. However, the present invention is not limited to such through hole and lead, and sectional profiles of the through hole and the lead, for example, can be of not only a circle but also an ellipse or other shapes. Further, there may be a case in which the lead is not inserted in the through hole for example when flow soldering of a surface mount component or when merely forming an electrical connection between conductor patterns formed on upper and lower surfaces of the board. The inner diameter of the through hole in such case can be smaller than that in the case where the lead is inserted through the through hole, and the inner diameter in the former occasion can be, for example, 0.4 to 5 mm.

A conveyance speed of the board was set at about 0.5 to 2.0 mm/min. The nozzle for spraying flux was located under the board at a distance of about 30 to 50 mm from the lower surface of the board. The nozzle had a spreading angle of about 20 to 90 degrees, and the flux was sprayed from the nozzle at such spreading angle. A speed of reciprocating motion of the nozzle was about 100 to 400 mm/sec., and the nozzle was reciprocated over a distance which was substantially the same as the width of the used printed circuit board. The used flux contained rosin and an organic acid (active ingredient) of about 3 to 20 % by weight, and isopropyl alcohol (solvent) of about 80 to 97 % by weight. The flux further contained a matting agent at a slight amount (less than 1 % by weight). An ambient gas surrounding the board was sucked at a displacement rate of about 10 to 20 m³/min. through an exhaust duct located above the conveyance line of the board.

After the application of the flux under the conditions as described above, a preheating step and a solder material supplying step were conducted to complete the flow soldering process similarly to Embodiment 2. In this process, a conveyance speed of the board was the same as that in the spray fluxer as described above, the board was preheated to about 100 to 120 °C (which is a temperature of a land portion locating on the lower surface of the board), and a lead-free solder material of an Sn-Cu based material or an Sn-Ag-Cu based material in a molten state at a temperature of about 245 to 260 °C was supplied to the board from its lower surface side to form a fillet made of the solder material. Thus, an electronic circuit board was produced.

According to thus produced electronic circuit board, it was confirmed that the solder material adhered to even the surface of the land portion locating on the upper surface of the board, and the occurrence of the "insufficient rising" effectively prevented.

More specifically, we studied a relationship of a distance between the nozzle and the board (hereinafter, which is simply referred to as a "nozzle distance") with rising of the solder material by subjecting the board to the flow soldering process while varying the nozzle distance. As an index of the rising, we measured an outer diameter of a bottom section of a fillet formed on the surface portion of the land. The fillet formed on the surface portion was, in other words, an upper fillet portion of the fillet 16 shown in Fig. 3, which fillet portion projects from the upper surface of the board and has a subconical shape. Hereinafter, the outer diameter of the bottom section is simply referred to as an "upper fillet diameter". The printed circuit board used herein was made of a glass epoxy material and had a length of about 180 mm, a width of about 140 mm and a thickness of about 1.6 mm, and had through holes having an inner diameter of about 0.9 mm. The board had lands which were made of copper so as to form the wall of the through hole and which had portions locating on the upper and lower surfaces of the board the printed circuit board. Portions of the land locating on the upper and lower surfaces had an outer diameter of about 2.0 mm. A lead made of tin plated iron was inserted into the through hole. Results are shown in Table 1.

**Table 1**

| Relationship between Nozzle Distance and Upper Fillet Diameter | |
|---|---|
| Nozzle Distance (mm) | Upper Fillet Diameter (mm) |
| 30 | 1.55 |
| 40 | 1.58 |
| 50 | 1.50 |
| 60 | 1.42 |
| 80 | 1.38 |
| 100 | 1.17 |
| 125 | 1.22 |
| 150 | 1.15 |

According to Table 1, it is understood that the outer diameter of the upper fillet in the case of selecting the nozzle distance in a range of 30 to 80 mm, for example 30 to 60 mm and especially 30 to 50 mm is larger than that in the case selecting the nozzle distance in the range of 100 mm or more as in the conventional flow soldering process and apparatus, and thus the solder material sufficiently rises and spreads over the upper surface of the board. Therefore, this means that the rising of the solder material along the through hole can be improved by selecting the nozzle distance in the range of about 30 to 80 mm, preferably about 30 to 60 mm, and more preferably 30 to 50 mm.

### Industrial Applicability

According to the present invention, there is provided the spraying mode flux applying method in the flow soldering process for mounting the electronic component onto the board by means of the solder material, which method enables the solder material sufficiently to be supplied into the through hole formed through the board, and also provided the device for conducting such method (i.e. the flux applying device such as a spray fluxer). Furthermore, according to the present invention, there is also provided the flow soldering process utilizing the flux applying method as well as the apparatus for conducting the flow soldering process (i.e. a flow soldering apparatus). As to the electronic circuit board which is produced by the flow soldering process, the occurrence of the "insufficient rising" is effectively reduced even though the lead-free solder material is used as the solder material in especial, and the high connecting strength of the connection part of the solder material can be assured.

The present application claims a priority under the Paris Convention to Japanese Patent Application No. 2000-290256 filed on September 25, 2000, entitled "METHOD FOR APPLYING FLUX, FLOW SOLDERING PROCESS, AND APPARATUSES FOR THEM AND ELECTRONIC CIRCUIT BOARD". The contents of that application are incorporated herein by the reference thereto in their entirety.

## Claims

1. A method for applying flux which comprises an active ingredient and a solvent onto a board by spraying the flux toward the board from a nozzle in a flow soldering process for mounting an electronic component onto the board by means of a solder material, wherein the flux is sprayed and adheres to the board while substantially remaining in a state of solution.

2. A method for applying flux which comprises an active ingredient and a solvent onto a board by spraying the flux toward the board from a nozzle in a flow soldering process for mounting an electronic component onto the board by means of a solder material, wherein a distance between the nozzle and the board which is located over the nozzle is 30 to 60 mm.

3. The method according to claim 1 or 2, wherein the flux is applied to a region of a wall of a through hole formed through the board, and the region is from a lower surface of the board which is closer to the nozzle to a level of at least one third of a thickness of the board in a direction of the thickness of the board.

4. The method according to claim 3, wherein the flux is applied to a whole region of the wall.

5. The method according to claim 1 or 2, wherein the solder material is a lead-free solder material selected from the group consisting of an Sn-Cu based material, an Sn-Ag-Cu based material, an Sn-Ag based material, an Sn-Ag-Bi based material and an Sn-Ag-Bi-Cu based material.

6. A flow soldering process, which comprises the method for applying the flux according to claim 1 or 2.

7. The process according to claim 6, which further comprises applying the flux onto the board by contacting foamed flux with the board.

8. An electronic circuit board produced by soldering an electronic component to the board by means of a solder material according to the process of claim 6.

9. A device for applying flux, which is used in a flow soldering process for mounting an electronic component onto a board by means of a solder material, **characterized in that** the device comprises a nozzle for applying the flux comprising an active ingredient and a solvent onto the board by spraying the flux toward the board such that the flux adheres to the board while substantially remaining in a state of solution.

10. A device for applying flux, which is used in a flow soldering process for mounting an electronic component onto a board by means of a solder material, **characterized in that** the device comprises a nozzle for applying the flux comprising an active ingredient and a solvent onto the board by spraying the flux toward the board, and a distance between the nozzle and the board which is located over the nozzle is 30 to 60 mm.

11. The device according to claim 9 or 10, wherein the nozzle applies the flux onto a region of a wall of a through hole formed through the board, and the region is from a lower surface of the board which is closer to the nozzle to a level of at least one third of a thickness of the board in a direction of the thickness of the board.

12. The device according to claim 11, wherein the nozzle applies the flux onto a whole region of the wall.

13. The device according to claim 9 or 10, wherein the solder material is a lead-free solder material selected from the group consisting of an Sn-Cu based material, an Sn-Ag-Cu based material, an Sn-Ag based material, an Sn-Ag-Bi based material and an Sn-Ag-Bi-Cu based material.

14. An apparatus for flow soldering, which comprises the device for applying the flux according to claim 9 or 10.

15. The apparatus according to claim 14, which further comprises a device for applying the flux by contacting foamed flux with the board.
